## Europäisches Patentamt

(19) **European Patent Office**

Office européen des brevets

(11) Publication number: **0 200 333**
**B1**

(12) # EUROPEAN PATENT SPECIFICATION

(45) Date of publication of the patent specification:
28.02.90

(51) Int. Cl.⁴: **H01J 37/305, H01J 37/02**

(21) Application number: **86302043.4**

(22) Date of filing: **19.03.86**

(54) Ion beam processing method and apparatus.

(30) Priority: **24.04.85 US 726713**

(43) Date of publication of application:
**10.12.86 Bulletin 86/45**

(45) Publication of the grant of the patent:
**28.02.90 Bulletin 90/9**

(84) Designated Contracting States:
**DE FR GB NL**

(56) References cited:
**FR-A- 2 284 980**
**FR-A- 2 363 882**
**US-A- 3 699 334**

**PATENT ABSTRACTS OF JAPAN, vol. 1,
no. 127 (E-77), 21st October 1977, page 5684 E 77; &
JP-A-52 62 496**
**PATENT ABSTRACTS OF JAPAN, vol. 8,
no. 206 (E-267)[1643], 20th September 1984; &
JP-A-59 92 526**
**PATENT ABSTRACTS OF JAPAN, vol. 9,
no. 61 (E-303)[1784], 19th march 1985; & JP-A-59 201 357**

(73) Proprietor: **MICRION LIMITED PARTNERSHIP, 30 Tozer Road, Beverly Massachusetts 01915(US)**

(72) Inventor: **Doherty, John A., Sudbury Massachusetts 01776(US)**
Inventor: **Ward, Billy W., Rockport Massachusetts 01966(US)**
Inventor: **Shaver, David C., Carlisle Massachusetts 01741(US)**

(74) Representative: **Rackham, Stephen Neil et al, GILL JENNINGS & EVERY 53-64 Chancery Lane, London WC2A 1HN(GB)**

## Description

The present invention relates to an ion beam processing method and apparatus and more particularly concerns the use of a submicron focused ion beam to sputter etch targets that are nonconductors in a precise and highly controlled manner. This invention provides a way of repairing optical and ion projection masks, and x-ray lithography masks and reticles.

The principle technical difficulty which arises in etching insulators is associated with the inability of these insulators to drain the charge that is deposited by an ion beam during the etching process. The local potential may reach nearly the potential of the incident beam and if this occurs it seriously degrades the beam shape. The beam position is then no longer a reliable function of the electronic driving signals.

A search has uncovered the following patent specifications US-A 3 219 817, US-A 3 665 185, US-A 3 845 305, US-A 3 878 392, US-A 4 052 614, US-A 3 699 334, US-A 4 249 077, US-A 4 381 453, US-A 4 466 839, GB-A 999 380, JP-A 5 262 496 and US-A 4 503 329 publications of Helmut Liebl entitled "Design of a Combined Ion and Electron Microprobe Apparatus" in Int. J. Mass. Spesctrom. Ion Phys., 6 Nos. 5–6 (1971), pp. 401–412; of C.W. Magee and W.L. Harrington entitled "Depth profiling of Sodium in $SiO_2$ Films by Secondary Ion Mass Spectrometry" in Appl. Phys. Lett. 33(2), 15 July 1978, pp 193–196; of K. Wittmaack entitled "Primary Ion Change Compensation in SIMS Analysis of Insulators" in J. App. L. Phys. 50(1), January 1979, pp 493–497; and of R. Levi-Setti entitled "Secondary Electron and Ion Imaging in Scanning Ion Microscopy" in Scanning Electron Microscopy, 1983, pp 1–22. Other prior art found includes US-A 3 665 185, US-A 3 920 989, US-A 4 249 077, US-A 4 361 762, US-A 4 447 724, US-A 4 463 255, US-A 4 453 078, US-A 3 920 989, US-A 4 249 077, US-A 4 361 762, US-A 4 447 724, JP-A 5 992 526, JP-A 59 201 357, FR-A 2 284 980, and FR-A 2 363 882.

These show it is known to have an ion beam processing apparatus comprising, an ion beam source including, means to provide a finely focused ion beam for impingement at a point upon a substrate surface in a predetermined surface plane, an electron beam source, including means for directing the electron beam towards the surface plane in a region embracing and surrounding the said point in the surface plane impinged upon by the ion beam, the electron beam neutralizing any surface charge in the surface plane caused by the ion beam so that defocusing and deflection of the ion beam in the surface plane by such a charge build up is reduced, detecting means for sensing secondarily emitted particles from the surface plane, the detecting means comprising an electron and ion detector for detecting electrons and ions secondarily emitted from the surface of the substrate in response to impingement by the ion beam and control means responsive to signals provided by the detecting means for controlling the ion beam source and the electron beam source to coact and cause the ion beam to etch the surface plane in a required manner and at a required location.

The object of the invention is to provide an ion beam processing method, wherein the processes are as unperturbed as practical.

According to the invention the ion beam processing apparatus is characterised in that the apparatus also includes grid means interposed between the electron and ion detector and the surface plane for selectively establishing an electric field that prevents electrons from entering said electron and ion detector whilst allowing ions to enter, and means for selectively biasing the grid means to establish the electric field.

A particular example of a method and apparatus in accordance with this invention will now be described with reference to the accompanying drawings; in which:

Figure 1 is a block diagram of a system according to the invention; and

Figure 2 is a schematic representation of the etching process according to the invention.

The system includes an ion source 11 providing ions focused by a lens 12 to form a finally focused ion beam 14 that is deflected by deflecting plates 13 to impinge upon surface 15 of substrate 16. A low energy electron gun 17 has an electron source focused by lens 18 to form a beam of electrons 21 that may pass through control elements 22 to form a focused spot of electrons that bathe a portion of surface 15 surrounding the point where ion beam 14 is sharply focused upon surface 15. Control element 22 may receive signals through multiplexer control 34 for deflecting or blanking the flooding electron beam.

An ion detector 24 detects ions sputtered from surface 15 to provide a signal to system computer 6. Electron and ion detector 26 may detect electrons and ions sputtered from surface 15 through grid 27 when grid 27 is appropriately biased to provide a signal through operational amplifier 30 that is also applied to system computer 6. System computer 6 controls bias control 31 and relay 32 connected to its arm 33 to selectively connect grid 27 to ion selective or electron selective potentials provided on correspondingly designated terminals of bias control 31. Typical electron and ion selective potentials are within the ranges of +300 to +600 volts and -300 to -2000 volts, respectively. Multiplexer control 34 may provide a deflection signal to deflection plates 22 of electron gun 17. System computer 6 may also provide a deflection signal to deflection amplifier 35 that energizes deflection plates 13.

The components of the system are known in the art and not described in detail herein to avoid obscuring the principles of the invention. For example, the ion source 11 my be one commercially available from FEI Company of Beaverton, Oregon. the low energy electron gun 17 may be one commercially available from Kimball Physics of Wilton, N. H. the electron and ion detector 26 may comprise a channel electron multiplier commercially available from Galileo of Sturbridge, Massachusetts.

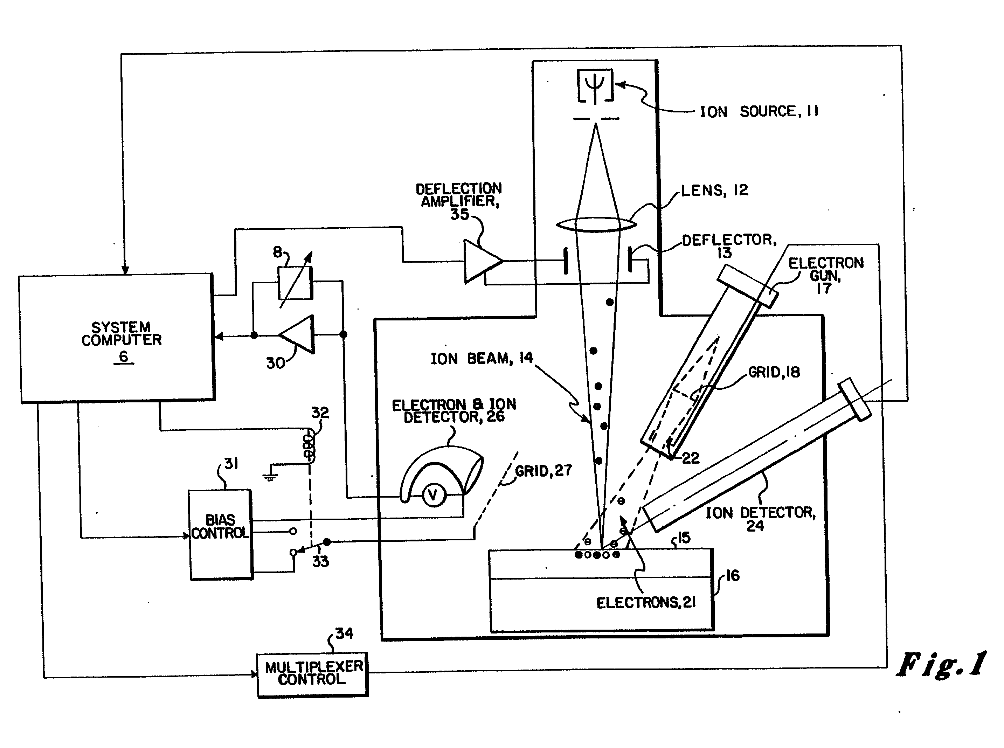

Having described the system arrangement, its mode of operation will be described. The system of FIG. 1 is useful in imaging, neutralizing ion charge and detecting the end point of a sputtering process. To this end ion beam 14 originates from a liquid metal ion source 11 providing ions that are accelerated and focused by electrostatic lens 12. Deflector 13 may precisely position ion beam 14 over a field of view on surface 15 typically approximately one square millimeter in area.

When ion beam 14 impinges upon surface 15 of substrate 16, a number of events occur.

(1) Low energy secondary electrons are generated.

(2) Positive and negative low energy secondary ions are generated.

(3) Atoms are sputtered away from surface 15.

(4) Primary ions from beam 14 are implanted into surface 15.

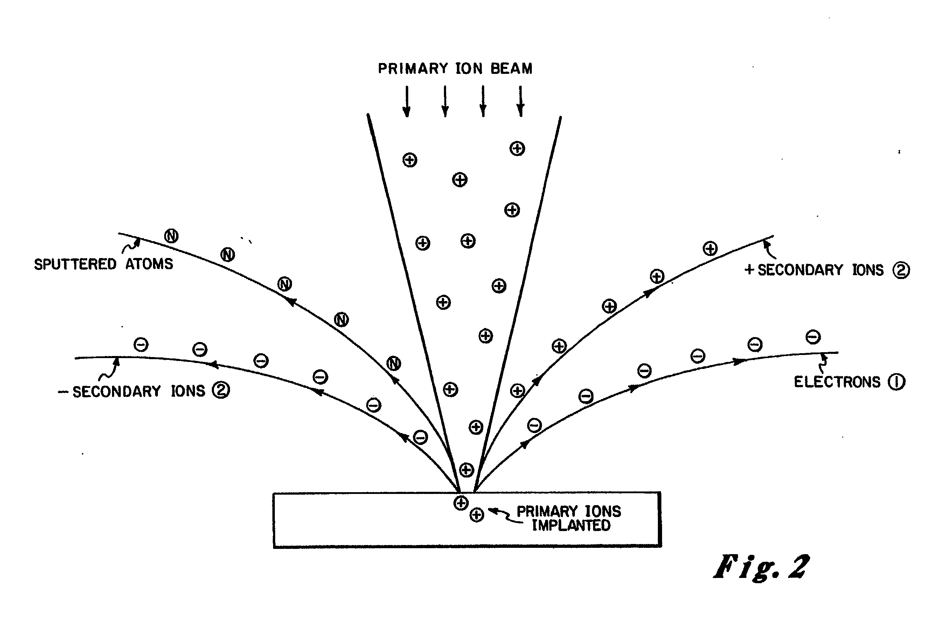

Referring to FIG. 2, there is shown a schematic representation of these processes. Each particle so generated comes only from the area directly beneath ion beam 14; hence, it is important that beam 14 be kept small and precisely located where it meets surface 15. If substrate 16 is not a conductor, a typical occurrence when etching on a semiconductor or insulating surface, the incident ion charge builds up under the beam and creates an electric defocusing field that interferes not only with the ion beam shape at the surface, but also the trajectories of ions and electrons as they leave the surface. A potential of only a few volts seriously degrades these processes. In the apparatus of FIG. 1, both electrons and ions are used to provide precise topological and compositional information relating to the surface under the focused ion beam 14. This information is useful for both surface imaging and determining the rates of sputtering.

By bathing the surface 15 around the point of impact from ion beam 14 with electron gun 17, these electrons neutralize the positive charge of the incident ions and thereby reduce the undesired defocusing field.

Multiplexer control 34 responds to signals from system computer 6 to provide a signal on electron gun control electrodes 22 that effectively controls the number of electrons on surface 15 so as to maintain sufficient low energy electrons to establish the desired neutralization. Switchable negative ion and electron detector 26 measures the number of electrons or ions escaping from surface 15 when grid 27 is biased to allow passage of them to provide electrical signals amplified by operational amplifer 30 of adjustable gain to provide an appropriate signal to system computer 6. Computer system 6 monitors these detected signals to control the electron current and timing such that the processes are as unperturbed as practical. By adjusting the electron flow upon surface 15 to neutralize the positive ion charge from beam 14, the processes remain free of disturbances caused by a charged surface.

While the system has been described in association with a system computer that may exercise control in accordance with known techniques, the invention could be practiced exercising the desired control manually. For example, deflection signals could be applied to deflector 13 manually by operating suitable potentiometers, relay 32 could be operated manually to switch between detecting for electrons and ions, and visual indicators, such as meters, could be placed at the output of operational amplifier 31 and scanning ion mass detector 24. The control signals applied to control element 22 could be manually controlled.

Furthermore, instead of displacing ion beam 14 by applying signals to deflector 13, ion beam 14 could remain stationary, and substrate 16 displaced. Substrate 16 could be supported on a mechanical stage, preferably having precision mechanical displacement mechanisms for displacement in mutually orthogonal directions between positions that can be readiliy determined to facilitate identifying the position where a feature is indicated, tyipcally by a sharp change in detected ion and/or electron current.

Preferably the deflection signals applied to deflector 13 are correlated with the signals received from channel electron multiplier 26 so that a sudden change in detected electron and/or ion current is associated with particular deflection signal amplitudes that correspond to particular locations on the substrate surface 15.

The invention is especially useful in repairing photooptical masks and reticles. Because large areas of the mask or reticle are highly insulating glass, these surfaces are subject to charge accumulation when bombarded by positive ions. The invention neutralizes this charge accumulation.

The invention may be used for opaque repair (etching of light blocking particles), transparent repair (making transmitting areas opaque) and imaging (so that defective areas can be precisely located with respect to the ion beam and other features of the substrate being repaired). All of these operations are enhanced by using the invention to neutralize charge accumulation and facilitate the process. Consider the following examples.

In the opaque repair process, the ion beam is used to sputter away the defect-forming material. Electron charge neutralization is used both in real time and in a multiplexed mode so that both ion imaging and secondary electron imaging may be used to locate the defect and monitor the sputtering process. For example, when the secondary electrons are being used to produce the desired image, the low energy flood electrons in beam 21 are attracted to detector 26 overloading the desired signal. Hence, depending on the conditions, electron gun 17 is switched on and off in a time division multiplexed way in cooperation with the primary ion beam 14 to simultaneously permit charge neutralization and secondary electron imaging.

For positive ion imaging (used to produce different types of contrast) the electron neutralizer is used concurrently with the primary ion beam 14. This approach is successful because the bias from bias control 31 to grid 27 when relay 32 is operated rejects the negatively charged low energy electrons of the neutralizing beam 21 while accepting secondarily emitted positive ions.

In the repair of opaque defects SIM detector 24 is used to quantitatively determine the types of ions leaving substrate 16. This information is processed by system computer 6 to adjust the etching location of beam 14 to minimize undesired etching of substrate 16, typically glass. Electron neutralization is used during this process in real time in a way analogous to the method of secondary ion imaging described above.

In clear repair the preferred method of producing opaque areas in the glass is to etch various types of optical diffusers as described in a paper by A. Wagner, D. Barr, D. Atwood and J. H. Bruning presented at the seventeen Electronic, Ion and Photo Beam Symposium in Los Angeles, California, in May 1983. This process requires precise and relatively long time etching of the insulating glass surface. Since precise optical elements must be etched, the electron neutralizing beam 21 is concentrated at the area of the ion etching beam 14.

It is advantageous to use ion beam induced conductivity to assist in charge neutralization. As ion beam 14 is scanned over surface 15, sufficient crystal damage and impurity implanatation occurs to produce a thin conductive layer in the upper 10 nanometers of the previously insulating glass substrate 16. This conductive layer does not disturb the desirable optical characteristic of the glass while providing an increased surface conducting area for flood electrons to reach the area of primary ion beam etching. Thus, it is unnecessary to finally focus electron flood beam 21, and a neutralizing beam may be used having a current density much less than that of primary ion beam 14. The ion beam current is typically $0.5 \times 10^{-9}$ amps with a density of about 1 amp/cm². The electron beam current is typically $10^{-6}$ amps with a current density $10^{-4}$ amps/cm². The electron beam current is much greater and its current density much less than the current and current density, respectively of the finely focused ion beam.

## Claims

1. An ion beam processing apparatus comprising, an ion beam source (11), including means (12, 13) to provide a finely focused ion beam (14) for impingement at a point upon a substrate surface (15) in a predetermined surface plane, an electron beam source (17), including means (18, 22) for directing the electron beam (21) towards the surface plane (15) in a region embracing and surrounding the said point in the surface plane impinged upon by the ion beam (14), the electron beam (21) neutralizing any surface charge in the surface plane (15) caused by the ion beam (14) so that defocusing and deflection of the ion beam (14) in the surface plane (15) by such a charge build up is reduced, detecting means (26) for sensing secondarily emitted particles from the surface plane, the detecting means comprising an electron and ion detector (26) for detecting electrons and ions secondarily emitted from the surface (15) of the substrate (16) in response to impingement by the ion beam (14), and control means (6) responsive to signals provided by the detecting means (24, 26) for controlling the ion beam source (11) and the electron beam source (17) to coact and cause the ion beam (14) to etch the surface plane (15) in a required manner and at a required location, characterised in that the apparatus also includes grid means (27) interposed between the electron and ion detector (26) and the surface plane (15) for selectively establishing an electric field that prevents electrons from entering said electron and ion detector (26) whilst allowing ions to enter, and means (31) for selectively biasing the grid means (27) to establish the electric field.

2. Ion beam processing apparatus according to claim 1, further comprising, multiplexer control means (34) for controlling the times when the ion source (11) and the electron source (17) operate to provide ion (14) and electron (21) beams impinging upon the surface plane (15) so that they impinge during mutually exclusive time intervals.

3. Ion beam processing apparatus according to claim 1 or 2, wherein the electron beam source (17) produces current and a current density which is much greater and less respectively than that of the iom beam source (11).

4. The use of an ion beam processing apparatus in accordance with any one of the preceding claims, including the steps of: directing a finely focused ion beam (14) upon a substrate surface (15) at a point in a predetermined surface plane, directing an electron beam (21) towards the surface plane (15) in a region embracing the said point in the surface plane impinged upon by the ion beam (14), the electron beam (21) neutralizing any surface charge in the surface plane (15) caused by the ion beam (14), so that defocusing and deflection of the ion beam (14) in the surface plane (15) by such a charge build up is reduced, sensing both secondarily emitted electrons and ions emitted from the surface in response to impingement by the ion beam (14) to sense characteristics of the surface, and positioning the ion beam to etch at a predetermined location which is identified by observing a change in the density of particles emitted from the surface as the ion beam (14) and the surface (15) are displaced relative to one another.

5. The use according to claim 4, further including the step of: damaging the surface (15) of the substrate (16) and implanting impurities therein with the ion beam (14) to produce a thin conductive layer substantially in the upper 10 nanometers of the substrate to provide an increased surface conducting area for electrons from the electron beam (21) to reach the said point of primary ion impingement upon the surface (15) without disturbing desirable optical characteristics of the substrate (16).

## Patentansprüche

1. Eine Ionenstrahlbearbeitungsvorrichtung mit folgenden Bestandteilen:

eine Ionenstrahlquelle (11) einschließlich Mitteln (12, 13) zur Lieferung eines fein fokussierten Ionenstrahls (14) zum Auftreffen auf einen Punkt auf einer Substratoberfläche (15) in einer vorgegebenen Oberflächenebene,

eine Elektronenstrahlquelle (17) einschließlich Mitteln (18, 22) zum Richten des Elektronenstrahls (21) auf die Oberflächenebene (15) in einem Bereich, der den Auftreffpunkt des Ionenstrahls (14) umschließt, wobei der Elektronenstrahl (21) jede durch den Ionenstrahl (14) in der Oberflächenebene (15) verursachte Oberflächenladung neutralisiert, so daß eine Defokussierung und Ablenkung des Ionenstrahls (14) in der Oberflächenebene (15) durch eine solche Ladungsbildung verringert wird,

Detektormittel (26) zum Feststellen von sekundär von der Oberflächenebene emittierten Teilchen, wobei diese Detektormittel einen Elektronen- und Ionendetektor (26) zum Feststellen des Vorhandenseins von Elektronen und Ionen enthalten, die sekundär als Reaktion auf das Auftreffen des Ionenstrahls (14) von der Oberfläche (15) des Substrats (16) emittiert werden, und

Steuermittel (6), die auf die von den Detektormitteln (24, 26) gelieferten Signale reagieren und dadurch die Ionenstrahlquelle (11) und die Elektronenstrahlquelle (17) so steuern, daß sie zusammenwirken und den Ionenstrahl (14) veranlassen, die Oberflächenebene (15) in der erforderlichen Weise und an der erforderlichen Stelle zu ätzen,

dadurch gekennzeichnet,

daß die Vorrichtung außerdem zwischen dem Elektronen- und Ionendetektor (26) und der Oberflächenebene (15) angeordnete Gittermittel (27) besitzt, die zum selektiven Aufbau eines elektrischen Feldes dienen, das verhindert, daß Elektronen in den erwähnten Elektronen- und Ionendetektor (26) gelangen, während sie die Ionen durchlassen, und Mittel (31) zur selektiven Vorspannungserzeugung für das Gittermittel (27) zwecks Aufbau eines elektrischen Feldes.

2. Eine Ionenstrahlbearbeitungsvorrichtung gemäß Anspruch 1, die außerdem folgende Bestandteile aufweist:

Multiplexersteuermittel (34) mit denen die Zeiten, während der die Ionenquelle (11) und die Elektronenquelle (17) in Betrieb sind, um einen Ionen- (14) und einen Elektronenstrahl (21) zu liefern, die auf die Oberflächenebene (15) auftreffen, so gesteuert werden, daß sie während sich gegenseitig ausschließender Zeitintervalle auftreffen.

3. Eine Ionenstrahlbearbeitungsvorrichtung gemäß Anspruch 1 oder 2, bei der die Elektronenstrahlquelle (17) einen Strom und eine Stromdichte erzeugt, die viel größer bzw. viel geringer als die der Ionenstrahlquelle (11) ist.

4. Die Verwendung einer Ionenstrahlaufbearbeitungsvorrichtung gemäß einem der vorhergenannten Ansprüche einschließlich folgender Schritte:

das Richten eines fein fokussierten Ionenstrahls (14) auf eine Substratoberfläche (15) an einer Stelle in einer vorher festgelegten Oberflächenebene,

das Richten eines Elektronenstrahls (21) auf die Oberflächenebene (15) in einem Bereich, der den genannten Punkt in der Oberflächenebene umgibt, in der der Ionenstrahl (14) auftrifft, wobei der Elektronenstrahl (21) jede, durch den Ionenstrahl (14) in der Oberflächenebene (15) verursachte Oberflächenladung neutralisiert, so daß die Defokussierung und Ablenkung des Ionenstrahls (14) in der Oberflächenebene (15) durch eine solche Ladungsbildung verringert wird,

wobei sowohl die sekundär emittierten Elektronen als auch die Ionen festgestellt werden, die von der Oberfläche als Reaktion auf das Auftreffen des Ionenstrahls (14) emittiert werden, um so die Oberflächeneigenschaften festzustellen, und

wobei der Ionenstrahl so positioniert wird, daß er an einer vorher festgelegten Stelle ätzt, die dadurch erkannt wird, daß ein Wechsel in der Dichte der Teilchen stattfindet, die von der Oberfläche emittiert werden, wenn der Ionenstrahl (14) und die Oberfläche (15) ihre Lage zueinander ändern.

5. Die Verwendung gemäß Anspruch 4, einschließlich folgendem weiteren Schritt:

Das Beschädigen der Oberfläche (15) des Substrats (16) und das Implantieren von Verunreinigungen mit dem Ionenstrahl (14) zwecks Herstellung einer dünnen, leitfähigen Schicht im wesentlichen in den oberen 10 nm des Substrats mit dem Ziel, einen größeren, an der Oberfläche leitenden Bereich für die Elektronen aus dem Elektronenstrahl (21) zur Verfügung zu stellen, um so den genannten Auftreffpunkt der Primärionen auf der Oberfläche (15) zu erreichen, ohne die gewünschten optischen Eigenschaften des Substrats (16) zu beeinträchtigen.

## Revendications

1°) Appareil de traitement par faisceau d'ions comprenant, une source de faisceau d'ions (11) incluant des moyens (12, 13) pour produire un faisceau d'ions finement focalisé (14) destiné à tomber en un point donné sur une surface de substrat (15) dans un plan de surface prédéterminé, une source de faisceau d'électrons (17) incluant des moyens (18, 22) pour diriger le faisceau d'électrons (21) vers le plan de surface (15) dans une zone contenant et entourant le point de la surface plane sur lequel tombe le faisceau d'ions (14), le faisceau d'électrons (21) neutralisant toute charge de surface produite dans le plan de surface (15) par le faisceau d'ions (14), de manière à réduire la défocalisation et la déviation du faisceau d'ions (14) produites par cette formation de charge dans le plan de surface (15), des moyens de détection (26) destinés à détecter les particules d'émission secondaire émises par le plan de surface, ces moyens de détection comprenant un détecteur d'électrons et d'ions (26) pour détecter les électrons et les ions d'émission secondaire émis par la surface (15) du substrat (16) lorsqu'elle est frappée par le faisceau d'ions (14), et des moyens de commande (6) répondant aux signaux fournis par les moyens de détection (24, 26) pour commander la source de faisceau d'ions (11) et la source de faisceau d'électrons (17) de façon qu'elles coopèrent et amènent le faisceau d'ions (14) à travers le plan de surface (15) d'une manière requise et en un point requis, appareil caractérisé en ce qu'il comprend également des moyens de grille (27) interposés entre le détecteur d'électrons et d'ions (26) et le plan de surface (15) pour établir sélectivement un champ électrique empêchant les électrons de pénétrer dans le détecteur d'électrons et d'ions (26) tout en laissant pénétrer les ions, et des moyens (31) destinés à polariser sélectivement les moyens de grille (27) pour établir le champ électrique.

2°) Appareil de traitement par faisceau d'ions selon la revendication 1, caractérisé en ce qu'il comprend en outre, des moyens de commande à multiplexeur (34) destinés à commander les instants où la source d'ions (11) et la source d'électrons (12) fonctionnent pour fournir le faisceau d'ions (14) et le faisceau d'électrons (21) tombant sur le plan de surface (15), de façon que ces faisceaux tombent pendant des intervalles de temps mutuellement exclusifs.

3°) Appareil de traitement par faisceau d'ions selon l'une quelconque des revendications 1 et 2, caractérisé en ce que la source de faisceau d'électrons (17) produit un courant et une densité de courant respectivement beaucoup plus grand et beaucoup plus petite que le courant et la densité de courant de la source de faisceau d'ions (11).

4°) Utilisation de l'appareil de traitement par faisceau d'ions selon l'une quelconque des revendications précédentes, comprenant les différentes étapes consistant à:
- diriger un faisceau d'ions finement focalisé (14) sur une surface de substrat (15) en un point se trouvant dans un plan de surface prédéterminé,
- diriger un faisceau d'électrons (21) vers le plan de surface (15) dans une zone contenant le point du plan de surface sur lequel vient tomber le faisceau d'ions (14), le faisceau d'électrons (21) neutralisant toute charge de surface produite par le faisceau d'ions (14) dans le plan de surface (15), de manière à réduire la défocalisation et la déviation du faisceau d'ions (14) produites par la formation de ces charges dans le plan de surface (15),
- détecter à la fois les électrons d'émission secondaire et les ions d'émission secondaire émis par la surface lorsqu'elle est frappée par le faisceau d'ions (14), de manière à détecter le caractéristiques de la surface, et
- positionner le faisceau d'ions pour effectuer une gravure en un point prédéterminé qui est identifié en observant une variation de la densité des particules émises par la surface lorsque le faisceau d'ions (14) et la surface (15) sont déplacés l'un par rapport à l'autre.

5°) Utilisation selon la revendication 4, caractérisée en ce qu'elle comprend en outre l'étape consistant à:

- détériorer la surface (15) du substrat (16) et implanter des impuretés dans celle-ci par le faisceau d'ions (14) pour produire une couche conductrice mince essentiellement dans les 10 nanomètres supérieurs du substrat, de manière à produire une zone conductrice de plus grande surface pour que les électrons provenant du faisceau d'électrons (21) atteignent le point d'impact des ions primaires sur la surface (15), sans perturber les caractéristiques optiques souhaitables du substrat (16).

ION SOURCE, 11

ELECTRON GUN, 17

LENS, 12

DEFLECTOR, 13

GRID, 18

ION DETECTOR, 24

22

ELECTRONS, 21

16

15

ION BEAM, 14

GRID, 27

DEFLECTION AMPLIFIER, 35

ELECTRON & ION DETECTOR, 26

30

8

32

33

31

34

BIAS CONTROL

MULTIPLEXER CONTROL

SYSTEM COMPUTER
6

*Fig.1*

PRIMARY ION BEAM

SPUTTERED ATOMS

+ SECONDARY IONS ②

− SECONDARY IONS ②

ELECTRONS ①

PRIMARY IONS
IMPLANTED

*Fig. 2*

EP 0 200 333 B1